# EUROPEAN PATENT APPLICATION

(11) **EP 2 343 961 A2**
(43) Date of publication of application: **13.07.2011**
(21) Application number: 10196194.4
(22) Date of filing: 21.12.2010
(51) Int. Cl.: H05K 9/00

(54) **Ground switching component**

(30) Priority: 08.01.2010 TR 201000142
(71) Applicant: Vestel Elektronik Sanayi ve Ticaret A.S., 45030 Manisa (TR)
(72) Inventor: Sariarslan, Kursat, 45030, Manisa (TR)
(74) Representative: Cayli, Hülya

(57) **Abstract**

This invention is related to a ground switching component and method which reduces the electromagnetic radiation of electronic devices. One of the aims of the invention is to reduce the electromagnetic radiation of the electronic devices. Another one is to achieve an electronic component which could be used with other various types of electronic devices for reducing the electromagnetic radiation.

## Description

### FIELD OF INVENTION

This invention is related to a ground switching component which reduces the electromagnetic radiation of electronic devices.

### PRIOR ART

Many electronic devices, produced today, contain several circuit elements that run on high frequencies and they cause electromagnetic pollutions. To limit the pollution, most of the devices are put to the Electromagnetic Compatibility (EMC) test. For reducing the electromagnetic radiation, producers use shields or ground the circuit elements. From time to time even electronic devices having multiple groundings may suffer from Electromagnetic Interference (EMI) due to structure of such electronic device; where some of the components within such electronic devices may radiate more electromagnetic signal compared to others

Especially in grounding, JP2000196289 numbered Japan Patent application is shown as an example. In this patent application, printed board having access to several electronic devices is grounded in many points with switches. In accordance with the selected operation mode, predetermined switches are activated and Electromagnetic Interference (EMI) related to activated devices are reduced. The teaching of this application was targeting to reduce EMI of activated section of electronic devices with the help of switches. But this kind of design needs some additional mechanical contact points over the PCB. This type of changes needs complex designs.

JP2000180488 numbered Japan Patent application gives another example of grounding method for reducing the emission values. In the application, unwanted noise of circuit elements are detected with noise evaluation part and they are grounded if they exceed the limit values. Evaluation equipments are necessary for this kind of structures. This makes the system more complex and unreliable.

### BRIEF DESCRIPTION OF THE INVENTION

This invention is related to a ground switching component and method which reduces the electromagnetic radiation of electronic devices. By the help of switches, grounding points and a control unit which controls the switching processes, electromagnetic radiation is reduced. To reduce the electromagnetic radiation of the electronic devices is the one of the aims of the invention. Another one is to achieve an electronic component which could be used with other various types of electronic devices for reducing the electromagnetic radiation.

### DETAILED DESCRIPTION OF THE INVENTION

In order to reach the aims of the invention, the application of ground switching component is displayed in the attached figures, wherein:

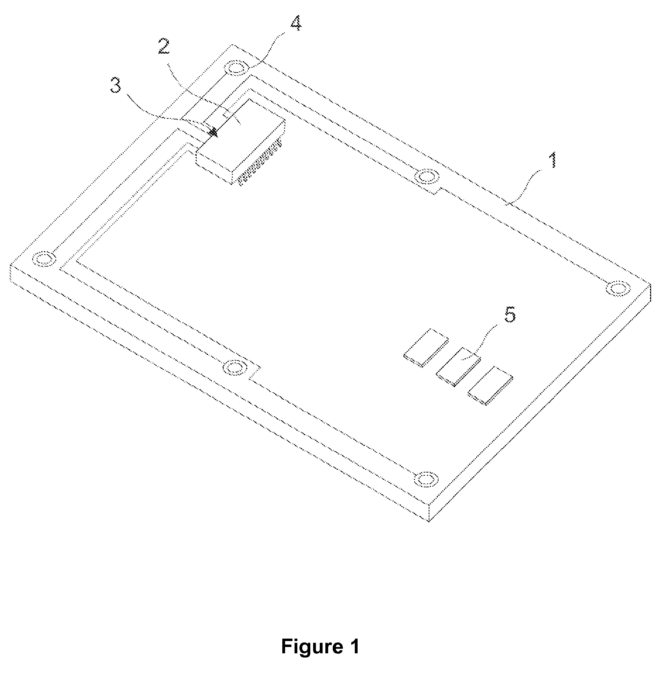

Figure 1 - Schematic view of an embodiment of the ground switching component used with screw holes.

The parts in figures are numbered separately and these numbers mean:
1. Printed Circuit Board (PCB)
2. Control unit
3. Switch
4. One of the grounding points
5. Circuit element

Ground switching component basically consists of a control unit (2), at least two switches (3) and at least two grounding points (4). These components can be located over the PCB (1) or on the chassis of the electronic device. The said board also includes some circuit elements (5) which work in high frequency such as mosfet relays or oscillators.

For reducing the electromagnetic radiation of circuit elements (5), they should be grounded on grounding points (4) like screw hole areas or any point over PCB (1). On the other hand, grounding is not possible for each component and also each of them may result in the production of unpredictable electromagnetic radiation.

For that reason, present grounding in many of the electronic devices is not enough to solve electromagnetic (EM) radiation problem. To minimize the EM radiation with available groundings all the grounding points (4) are connected to the control unit (2). The said control unit (2) opens and closes the connection of each grounding point (4) and the connection with common ground with the help of switches (3). After any of the switches (3) are opened, the related grounding point or points (4) loses its connection with system's common ground .In this case total electromagnetic energy of such electronic device will flow over available groundings; which will increase electromagnetic radiation of electronic paths connected to those groundings. At the same time in another location, one of the grounding points (4) will be connected to system's common ground through another switch (3) of the control unit (2). This will decrease electromagnetic radiation of one of the circuit elements (5).

Each of the circuit element's (5) electromagnetic radiation characteristic depends on its technical features. Even if all the switches (3) close and open one after another, their frequencies will not change. Furthermore, some of the peak frequency values may exceed the limit values during the switching process.

In order to solve this problem that occurs during switching, switching process will be carried out at very high frequency. By this means, although the radiation that some of the circuit components emitting at their own frequency is above the limit values, due to the lack of continuity at those emitting frequencies quasi peak values will be at lower levels.

The switch's (3) opening and closing cycle of frequency is controlled by the control unit (2). Its frequency should be determined according to the frequencies that the system circuit components radiate and the grounding points on the PCB. The preferred frequency of the control unit (2) is between 100 KHz and 3 MHz. By means of this high frequency interval, the switching frequency that is created by the control unit (2) will not have an adverse effect on the success of the electronic device at EMC tests.

Control unit (2) could be produced from any kind of microcontroller component or simple oscillator circuit. Switching cycles could have been triggered by these components or circuits.

Although the application of the invention explained above is on PCBs (1), its application can be expanded to other electronic devices that are prone to electromagnetic radiation such as RAMs, oscillators and regulators. The invention may also facilitate the reduction of electromagnetic radiation within these electronic devices. Like the screw holes used to mount the PCBs on chassis as grounding points, switched grounding can be done at various points of the circuit components by designing contact surfaces.

However, in order to switch via the use of screw holes on PCBs, either chassis must be grounded or there must be an electrical contact between the screw hole and the chassis. Although the switching of the grounding points (4) between on and off can be done in an order, they can also be grouped in this switching operation by following a defined switching pattern. But the whole switching process will be realized at high frequency, independent of the switching order.

The invention cannot be limited to the examples that are given above as an explanation of the subject. The invention is principally described in claims.

## Claims

1. A ground switching component that aims to reduce electromagnetic radiation within an electronic device that is comprised by
- at least two grounding points (4) that will enable the grounding of the electronic device with common ground of PCB Board (1),
- at least two switches (3) that connects each of the grounding points (4) with the system's common ground, and
- a control unit (2) that controls the opening and closing of the switches (3) at a predetermined frequency
- the control unit (2) that performs the continuous opening and closing cycle of the switches (3).in a predetermined sequence at a predetermined frequency.

2. A ground switching component according to claim 1, **characterized in that** each grounding point (4) is switched sequentially between 100 KHz and 3 MHz.

3. A ground switching component according to Claim 1, **characterized in that** each grounding point (4) opens and closes individually one after another.

4. A ground switching component according to Claim 1, **characterized in that** each grounding point (4) opens and closes in groups one after another.

5. A ground switching component according to any of the preceding claims, **characterized in that** it consists of a PCB having screws electrically isolated in order to prevent the access of the grounding at screw holes to the chassis by means of a screw for the purpose of controlling the switching on and off the connection of the grounding points (4) with the ground by the control unit (2).

6. A ground switching component according to the Claims 1 to 3, **characterized in that** it should ground the contact surfaces which are formed to ground the circuit elements (5) or the grounding points on the PCB in addition to the screw holes.

7. A ground switching component that aims to reduce electromagnetic radiation within an electronic device involves these steps;
- to use one or more switches which connect any of the grounding point to common ground in order to reduce electromagnetic radiation of at least one of the circuit elements ,
- after electromagnetic radiation of at least one circuit element decrease, to reduce another one of the circuit element's electromagnetic radiation, system opens one of the switch or switches and closes other switch or switches,
- Wherein switching cycle of switches and switching frequency are predetermined accordingly.

8. A ground switching component according to claim 7, **characterized in that** switching frequency is between 100 KHz and 3 MHz.
